# FASCICULE DE BREVET EUROPEEN

(11) **EP 1 302 558 B1**
(45) Date de publication et mention de la délivrance du brevet: **25.01.2012**
(21) Numéro de dépôt: 02292399.9
(22) Date de dépôt: 30.09.2002
(51) Int. Cl.: C23C 10/06, C23C 16/04, C23C 16/12, B21D 47/00

(54) **Procédé de protection par aluminisation de pièces métalliques de turbomachines munies de trous et cavités**
Verfahren zum Schutz bei der Aluminisierung von Turbomaschinenmetallteilen mit Löchern und Hohlräumen
Process of protection by aluminization of metallic parts of turbomachines having holes and cavities

(30) Priorité: 16.10.2001 FR 0113315
(43) Date de publication de la demande: 16.04.2003
(73) Titulaire: SNECMA, 75015 Paris (FR)
(72) Inventeur: Fournes, Jean-Paul, 91490 Dannemois (FR); Oberlaender, Guillaume, 75014 Paris (FR); Richin, Catherine, 91410 Roinville sous Dourdan (FR)
(74) Mandataire: Joly, Jean-Jacques

(56) Documents cités:
- EP-A- 0 476 676
- EP-A- 1 076 111
- GB-A- 1 549 845
- US-A- 3 075 494
- US-A- 4 132 816
- US-A- 5 368 888
- US-A- 5 928 725

## Description

### Arrière-plan de l'invention

L'invention concerne la protection contre l'oxydation à haute température de pièces métalliques présentant des trous et cavités.

Le domaine d'application de l'invention est celui de la protection de pièces de turbomachines telles que des pièces de turbines, notamment des aubes, qui présentent des cavités internes pour la circulation d'air de refroidissement, celui-ci étant amené par des trous ou passages d'alimentation qui traversent généralement les pieds des aubes et étant évacué par des trous d'évents qui s'ouvrent à la surface externe des aubes.

En dépit de l'utilisation de superalliages métalliques, généralement à base nickel ou cobalt, il est nécessaire de munir de telles pièces d'un revêtement de protection contre l'oxydation capable de les protéger contre l'oxydation aux températures toujours plus élevées auxquelles on cherche à faire fonctionner les turbomachines afin d'optimiser leur rendement.

Un procédé de protection couramment utilisé est l'aluminisation par dépôt en phase vapeur. Ce procédé est bien connu ; on pourra en particulier se référer au document FR 1 433 497. Il consiste à placer une ou plusieurs pièces à protéger dans une enceinte dans laquelle circule un mélange gazeux comprenant un composé de l'aluminium, tel qu'un halogénure, et un gaz de dilution ou gaz porteur. L'halogénure est produit par réaction entre un halogène, par exemple chlore ou fluor, et un donneur métallique contenant de l'aluminium, par exemple un alliage métallique d'aluminium avec un ou plusieurs des constituants métalliques du matériau des pièces à protéger. Le gaz de dilution assure la dilution et l'entraînement du mélange gazeux pour amener l'halogénure au contact des pièces afin de former le dépôt souhaité à la surface de celles-ci. Le gaz de dilution couramment utilisé est l'argon. L'hydrogène est également mentionné dans le document FR 1 433 497 précité, mais son utilisation est très difficile en pratique en raison de sa dangerosité.

Le procédé classique d'aluminisation par dépôt en phase vapeur permet certes la formation d'un revêtement de protection satisfaisant à la surface externe des pièces, mais aucun revêtement n'est formé sur les parois internes des trous et cavités. Or, en dépit de la circulation d'air de refroidissement, la température de ces parois internes peut atteindre au moins localement des valeurs telles que des phénomènes d'oxydation interne peuvent se produire. La déposante a observé que cette oxydation peut se traduire par un écaillage du matériau constitutif des pièces et que des écailles arrachées par le flux d'air sur les parois internes peuvent obstruer partiellement des trous d'évents. Il en résulte une irrégularité du film protecteur formé sur la paroi externe par l'air s'échappant à travers les trous d'évents, et l'apparition de points chauds entraînant des dégradations locales des pièces.

En outre, une accumulation de dépôt a tendance à se former autour des orifices extérieurs des trous. Cela se traduit par la présence d'étranglements qui peuvent affecter de façon importante la circulation de l'air de refroidissement en créant des pertes de charge et en favorisant l'apparition de zones de stagnation d'air. Un réusinage des trous est envisageable mais est délicat à réaliser, car il doit être très précis et doit éviter de dégrader le revêtement de protection au voisinage des orifices, et il constitue une opération supplémentaire coûteuse.

La déposante a encore observé que des surépaisseurs importantes de dépôt, en particulier autour des orifices d'entrée d'air au niveau de pieds d'aubes, présentent un risque non négligeable de fissuration non seulement du revêtement, mais aussi du matériau métallique des aubes.

En effet, contrairement au matériau des aubes, le revêtement est sujet à fissuration causée par le cyclage thermique auquel les aubes sont soumises. Lorsque le revêtement est épais, une fissure qui se produit à travers le revêtement a tendance à se propager dans le matériau sous-jacent (ce qui n'est pas le cas avec un revêtement de faible épaisseur).

Or, la fissuration du matériau des aubes au niveau de leurs pieds peut aller jusqu'à une destruction des aubes, donc avoir des conséquences potentiellement dramatiques.

### Objet et résumé de l'invention

L'invention a pour but de proposer un procédé permettant de réaliser une protection par aluminisation tant sur les parois externes que sur des parois internes de pièce métallique de turbomachine munie de trous et/ou cavités, communiquant avec l'extérieur afin d'éviter les problèmes ci-dessus.

Ce but est atteint grâce à un procédé selon la revendication 1.

L'allongement du libre parcours moyen des molécules de gaz porteur, permet une pénétration plus aisée dans les trous et/ou cavités de la pièce et donc permet d'amener des molécules de précurseur gazeux plus en profondeur au contact de surfaces internes de la pièce. Cela permet à la fois de former un revêtement de protection sur des surfaces internes et de limiter la formation de surépaisseurs de dépôt au niveau des orifices des trous et/ou cavités.

Avantageusement, la pièce est réalisée avec des trous qui, au moins dans leur portion voisine de l'orifice extérieur, présentent un diamètre croissant vers l'extérieur. La forme évasée des trous permet de compenser une épaisseur de revêtement décroissante à partir de l'orifice extérieur pour obtenir un trou de diamètre sensiblement constant souhaité après aluminisation.

### Brève description des dessins

L'invention sera mieux comprise à la lecture de la description faite ci-après, à titre indicatif mais non limitatif, en référence aux dessins annexés sur lesquels :
- la figure 1 est une vue schématique en élévation d'une aube de turbine munie d'un circuit interne de refroidissement ;
- la figure 2 est une vue schématique en coupe suivant le plan II-II de la figure 1 ;
- la figure 3 est une vue très schématique d'une installation permettant la mise en oeuvre d'un procédé selon l'invention ; et
- les figures 4 à 6 montrent de façon très schématique un revêtement formé par aluminisation au voisinage de l'orifice d'un trou d'évent d'une aube telle que celle des figures 1 et 2, respectivement avec un procédé de l'art antérieur, avec un procédé selon l'invention et avec une variante d'un procédé selon l'invention.

### Description détaillée de modes de réalisation

Des modes de réalisation de l'invention seront décrits ci-après dans le cas de l'application du procédé à la formation de revêtement de protection pour une aube de turbine à gaz présentant des trous et cavités internes dans lequel peut circuler de l'air de refroidissement. Il apparaîtra immédiatement que le procédé convient pour toute pièce métallique de turbomachine présentant des trous et/ou cavités communiquant avec l'extérieur.

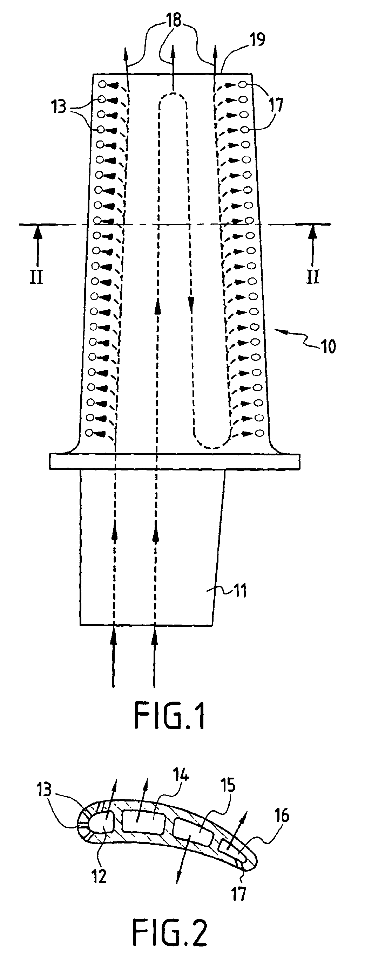

Une aube 10 de turbine à gaz est montrée schématiquement par les figures 1 et 2.

De façon classique, l'aube 10, réalisée en superalliage à base nickel ou cobalt, comprend des cavités internes 12, 14, 15, 16 s'étendant sur la hauteur de l'aube et permettant la circulation d'air de refroidissement.

La cavité 12 située du côté du bord d'attaque est alimentée par un passage formé dans le pied d'aube 11. L'air parvenant dans la cavité 12 s'échappe par des trous 13 au niveau du bord d'attaque de l'aube et forme un film d'air protecteur sur la face extérieure du bord d'attaque.

Les cavités 14, 15, 16 sont parcourues en série par de l'air admis dans la cavité 14 à travers un passage formé dans le pied d'aube. Cet air s'échappe à travers des trous d'évent 17 qui débouchent à l'intrados de l'aube au voisinage du bord de fuite et s'ouvrent dans la cavité 16. D'autres trous d'évent pourront être formés du côté intrados, débouchant dans la cavité 15, voire dans la cavité 14.

Des trous schématisés en 18 sur la figure 1 font communiquer le sommet d'aube 19 avec les cavités internes. Les trous 18 correspondent aux emplacements de supports des noyaux utilisés pour réserver les cavités internes lors de la coulée de l'aube.

La circulation de l'air de refroidissement est schématisée par des traits interrompus et des flèches sur les figures 1 et 2.

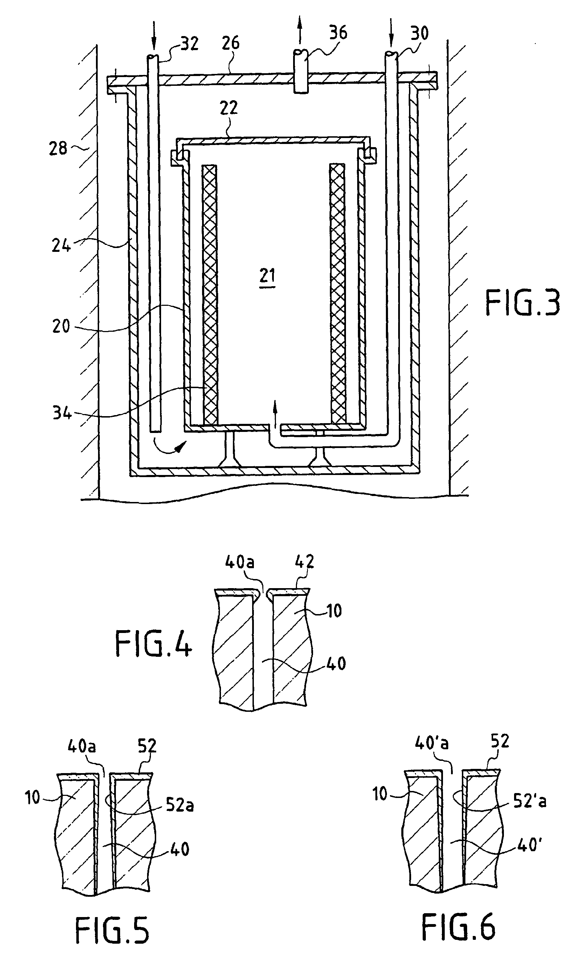

Un revêtement de protection contre l'oxydation à haute température est formé sur la surface externe et des surfaces internes de l'aube 10 par un procédé selon l'invention en utilisant par exemple l'installation d'aluminisation en phase vapeur illustrée par la figure 3.

Cette installation comprend une boîte 20 fermée par un couvercle 22 de façon non étanche et supportée à l'intérieur d'un pot 24. Ce dernier est obturé de façon étanche par un couvercle 26 et est disposé dans un four 28.

Une canalisation 30 alimente l'enceinte 21 définie par la boîte 20 en gaz porteur (ou gaz de dilution). Le même gaz est injecté dans le pot 24, à l'extérieur de la boîte 20, par une canalisation 32. Ce gaz de balayage est recueilli par une canalisation 36, à travers le couvercle 26.

A l'intérieur de la boîte 20 est disposé un donneur 34 sous forme par exemple granulés ou poudre. Le donneur est généralement constitué par un alliage d'aluminium et d'un ou plusieurs métaux constitutifs des aubes à aluminiser. Un activateur permettant de former un halogénure avec le donneur est également introduit dans l'enceinte sous forme de poudre. Des activateurs couramment utilisés sont les fluorures d'ammonium NH₄F et d'aluminium AlF₃.

Des aubes à aluminiser sont disposées dans l'enceinte 21 en étant supportées ou suspendues au moyen d'outillages (non représentés) de façon bien connue en soi.

La température du four est réglée pour que règne à l'intérieur du four une température, généralement comprise entre 950°C et 1200°C à laquelle un halogénure gazeux se forme par réaction entre le donneur et l'activateur. L'aluminisation est réalisée par dépôt par décomposition de l'halogénure au contact des surfaces des aubes. Le gaz porteur a pour fonction de faciliter le transport des molécules d'halogénure.

Selon un premier mode de mise en oeuvre de l'invention, le gaz porteur utilisé est de l'hélium.

En comparaison avec l'argon, qui est habituellement utilisé, les molécules d'hélium ont un libre parcours moyen nettement supérieur, à pressions égales. Le libre parcours moyen L est usuellement défini comme proportionnel à 1/P.D² où P est la pression et D le diamètre moléculaire. Le rapport L_{He}/L_{Ar} entre les libres parcours moyens des molécules d'hélium et d'argon est environ égal à 3, sous pression atmosphérique.

Grâce à l'allongement du libre parcours moyen des molécules de gaz porteur, la diffusion d'halogénure au sein des trous et cavités de l'aube est facilitée, de sorte qu'une aluminisation peut être réalisée sur des surfaces internes de l'aube, au moins sur une certaine distance à partir des orifices extérieurs des trous et cavités. Une protection interne contre l'oxydation à haute température est ainsi réalisée.

Cela est illustré très schématiquement par les figures 4 et 5.

La figure 4 montre le résultat d'une aluminisation classique sous argon au voisinage de l'orifice d'un trou d'évent 40 d'une aube. On constate que le dépôt 42 formé par aluminisation est limité à la surface externe et ne se prolonge pas sur la paroi interne du trou 40, et donc encore moins sur des parois de cavité interne de l'aube. De plus, le dépôt 42 obstrue en partie l'orifice extérieur 40a du trou 40 et perturbe l'écoulement de l'air.

Grâce à l'utilisation d'un gaz porteur ayant des molécules dont le libre parcours moyen est supérieur, la figure 5 montre que le dépôt 52 formé par aluminisation s'étend non seulement sur la surface externe de l'aube, mais aussi sur la surface interne du trou d'évent 40 et, de là, peut se prolonger sur la surface de cavité interne de l'aube.

Comme le montre (de façon exagérée) la figure 5, l'épaisseur de dépôt interne 52a décroît depuis l'orifice extérieur 40a du trou 40. La section de sortie est donc réduite, sans toutefois présenter la même restriction que dans le cas de la figure 4.

En variante, et afin d'éviter cette réduction de section du trou après aluminisation, l'aube pourra être réalisée avec des trous d'évents ayant une section progressivement croissante vers l'extérieur, comme le trou 40' de la figure 6. La variation de section est déterminée pour compenser la diminution d'épaisseur de dépôt interne 52'a observée depuis l'orifice extérieur 40'a, de sorte qu'après aluminisation, des trous d'évents sont obtenus de diamètre sensiblement constant ayant la dimension voulue. Aucune reprise d'usinage éventuelle des trous n'est nécessaire.

Selon un deuxième mode de mise en oeuvre de l'invention, le gaz porteur utilisé est l'argon, mais le processus d'aluminisation est réalisé sous pression réduite de manière également à allonger le libre parcours moyen des molécules de gaz porteur.

Ainsi, après chargement des aubes dans l'enceinte 21 de l'installation de la figure 3, et fermeture étanche du pot 24, l'atmosphère du pot 24 et de la boîte 20 est purgée sous argon et la pression est diminuée par pompage à travers la canalisation 28 de manière à amener la pression dans le pot 24 et la boîte 20 à une valeur relativement faible, par exemple inférieure à 5 kPa.

Ensuite, un débit continu d'argon est admis à travers la canalisation 30 de manière à maintenir dans le pot 24 et la boîte 20 une pression à une valeur inférieure à la pression atmosphérique. On choisira plutôt une valeur au plus égale à 50 kPa, de préférence au plus égale à 25 kPa, le rapport L_{Ar réd}./L_{Ar atm} entre les libres parcours moyens des molécules d'argon à pression réduite et à pression atmosphérique étant alors au moins égal à 2, et de préférence au moins égal à 4.

### Essais

Une aube de turbine semblable à celle des figures 1 et 2 a été aluminisée en utilisant une installation du type de celle de la figure 3, le donneur étant un alliage chrome-aluminium avec 30 % à 35 % d'aluminium et l'activateur étant AlF₃.

Le processus a été conduit à une température dans l'enceinte égale à environ 1150°C pendant une durée d'environ 3 h.

Trois essais A, B, C ont été réalisés, respectivement avec de l'argon sous pression atmosphérique (procédé d'aluminisation par dépôt en phase vapeur de l'art antérieur), avec de l'hélium et avec de l'argon sous une pression réduite environ égale à 13 kPa.

Le tableau ci-dessous indique les épaisseurs de revêtement (en µm) mesurées sur la surface externe de l'aube et sur la surface interne des cavités respectivement au voisinage du pied, au milieu et au voisinage du sommet.

| | | A | B | C |
|---|---|---|---|---|
| Sommet | externe | 90 | 90 | 90 |
| | interne | 0 | 25 | 50 |
| Milieu | externe | 90 | 85 | 95 |
| | interne | 0 | 0 | 70 |
| Pied | externe | 90 | 90 | 90 |
| | interne | 0 | 40 | 65 |

Alors qu'un revêtement externe sensiblement uniforme est obtenu dans tous les cas, seuls les procédés réalisés conformément à l'invention ont pu permettre de réaliser un revêtement de surfaces internes.

Le procédé utilisant l'argon à pression réduite a permis une aluminisation complète des surfaces internes des trous et cavités, un examen détaillé de celle-ci ayant révélé que les surfaces internes étaient revêtues intégralement avec une épaisseur minimale de 30 µm.

Par contre, le procédé utilisant l'hélium n'a pas permis de réaliser un revêtement interne jusqu'au coeur de l'aube.

On notera que, dans le cas de l'essai C (Ar à pression réduite), le rapport L_{Ar réd.}/L_{Ar atm.} était égal à environ 7,8, tandis que, dans le cas de l'essai B (He à pression atmosphérique), le rapport L_{He}/L_{Ar atm}. était égal à environ 3.

Le processus d'aluminisation avec gaz porteur constitué par l'hélium pourra être réalisé aussi sous pression réduite afin d'avoir un rapport L_{He réd}./L_{Ar atm.} supérieur à 3 et conduire à une aluminisation complète des surfaces internes de l'aube.

## Revendications

1. Procédé d'aluminisation par dépôt en phase vapeur pour la protection contre l'oxydation à haute température d'une pièce métallique de turbomachine comportant des trous et/ou cavités communiquant avec l'extérieur, procédé selon lequel au moins un précurseur gazeux du dépôt à réaliser comprenant un composé de l'aluminium étant amené au contact des surfaces de la pièce disposée dans l'enceinte, **caractérisé en ce qu'**il comprend les étapes consistant à :
charger la pièce métallique à aluminiser dans une enceinte ;
purger sous argon l'atmosphère à l'intérieur de l'enceinte et diminuer la pression par pompage de manière à amener la pression à l'intérieur de l'enceinte à une valeur inférieure à 5 kPa ;
admettre à l'intérieur de l'enceinte un débit continu d'argon de manière à maintenir dans l'enceinte une pression au plus égale à 25 kPa; et
maintenir à l'intérieur de l'enceinte une température comprise entre 950°C et 1200°C.

2. Procédé selon la revendication 1, **caractérisé en ce qu'**un donneur et un activateur sont disposés à l'intérieur de l'enceinte, ledit donneur étant un alliage chrome-aluminium avec 30 à 35% d'aluminium et ledit activateur étant AlF₃, la température à l'intérieur de l'enceinte étant égale à environ 1150°C pendant une durée de 3 heures et la pression à l'intérieur de l'enceinte étant maintenue par le débit continu d'argon à 13 kPa.

3. Procédé selon l'une des revendications 1 et 2, **caractérisé en ce que** la pièce est réalisée avec des trous qui, au moins dans leur portion voisine de l'orifice extérieur, présentent un diamètre croissant vers l'extérieur.

## Claims

1. A method of aluminization by vapor deposition for protecting a metal turbomachine part against high temperature oxidation, the part having holes and/or cavities communicating with the outside, in which method at least one gaseous precursor of the deposit to be made, comprising an aluminum compound, is brought into contact with the surfaces of the part placed in an enclosure, the method being **characterized in that** it comprises the steps of:
placing the metal part to be aluminized in an enclosure;
purging under argon the atmosphere inside the enclosure and reducing the pressure by pumping so as to bring the pressure inside the enclosure down to a value of less than 5 kPa;
admitting inside the enclosure a continuous flow of argon so as to maintain inside the enclosure the pressure at a value that is no greater than 25 kPa; and
maintaining inside the enclosure a temperature comprised between 950°C and 1200°C.

2. A method according to claim 1, **characterized in that** a donor and an activator are placed inside the enclosure, said donor being a chromium-aluminium alloy with 30% to 35% aluminium and said activator being AlF₃, the temperature inside the enclosure being equal to about 1150°C for a duration of 3 hours and the pressure inside the enclosure being maintained at 13 kPa by the continuous flow of argon.

3. A method according to claim 1 or claim 2, **characterized in that** the part is witch holes which, at least in the vicinity of their outside orifices, present a diameter that increases going towards the outside.

## Patentansprüche

1. Verfahren zur Aluminisierung mittels Gasphasenabscheidung für den Schutz eines Turbomaschinenmetallteils, das mit der Außenseite in Verbindung stehende Löcher und/oder Hohlräume aufweist, vor Oxidation bei hoher Temperatur, Verfahren, wobei wenigstens ein gasförmiger Vorläufer der herzustellenden Beschichtung, welcher eine Verbindung des Aluminiums umfaßt, mit den Oberflächen des in dem Raum angeordneten Teils in Kontakt gebracht wird, **dadurch gekennzeichnet, daß** es die Schritte umfaßt, die darin bestehen:
das zu aluminisierende Metallteil in einen Raum einzubringen,
die Atmosphäre innerhalb des Raums unter Argon zu reinigen und den Druck durch Pumpen zu verringern, derart, daß der Druck innerhalb des Raums auf einen Wert von unter 5 kPa gebracht wird,
in das Innere des Raums eine kontinuierliche Menge Argon einzuleiten, derart, daß in dem Raum ein Druck von höchstens gleich 25 kPa aufrechterhalten wird, und
innerhalb des Raums eine Temperatur im Bereich zwischen 950 °C und 1200 °C aufrechtzuerhalten.

2. Verfahren nach Anspruch 1, **dadurch gekennzeichnet, daß** in dem Raum ein Donator und ein Aktivator angeordnet sind, wobei der Donator eine Chrom-AluminiumLegierung mit 30 bis 35 % Aluminium ist und der Aktivator AlF₃ ist, wobei die Temperatur innerhalb des Raums über eine Dauer von 3 Stunden etwa gleich 1150 °C ist und der Druck innerhalb des Raums durch die kontinuierliche Argonmenge auf 13 kPa gehalten wird.

3. Verfahren nach einem der Ansprüche 1 und 2, **dadurch gekennzeichnet, daß** das Teil mit Löchern ausgebildet ist, die wenigstens in ihrem Abschnitt nahe der äußeren Öffnung einen nach außen zunehmenden Durchmesser aufweisen.
